# EUROPEAN PATENT APPLICATION

(11) **EP 3 722 895 A1**
(43) Date of publication of application: **14.10.2020**
(21) Application number: 19188258.8
(22) Date of filing: 25.07.2019
(51) Int. Cl.: G05B 13/02, H05K 3/30

(54) **METHOD USING A NEURAL NETWORK FOR GENERATION OF JETTING CONTROL PARAMETERS**

(30) Priority: 08.04.2019 EP 19167954
(71) Applicant: MYCRONIC AB (publ), 183 03 Täby (SE)
(72) Inventor: GRAFSTRÖM, Daniel, 123 48 Farsta (SE)
(74) Representative: AWA Sweden AB

(57) **Abstract**

A method for generating control instructions for operating an apparatus (1) forming a deposit of viscous medium (22) on a workpiece (23) is disclosed, comprising: obtaining (110) an environmental parameter affecting a rheological behaviour of the viscous medium; obtaining (120) a deposit parameter indicating a physical characteristic of the deposit to be formed by the viscous medium; and processing the environmental parameter and the deposit parameter through a neural network to generate (130) control instructions for use when operating the apparatus to form the deposit.

## Description

### TECHNICAL FIELD

The present disclosure generally relates to the field of jetting of viscous medium onto a workpiece. In particular, it relates to technologies for generating control instructions for operating an apparatus forming a deposit of viscous medium on the workpiece, and for generating a trained neural network model for providing such control instructions.

### BACKGROUND

Machines for forming deposits of viscous medium, for example solder paste or adhesive, onto a workpiece are software controlled. The software needs control instructions for how to apply the viscous medium to a specific workpiece. Typically, the control instructions are pre-processed off-line by means of an operator that provides input in terms of desired position and volume of the deposits. Thus, generally, the generation of the control instructions required to process a workpiece involves importing, to a generation program, workpiece data relating to a unique substrate, or a unique subset of workpiece, and defining, on basis of the workpiece data, where on the workpiece the deposits are to be formed.

When all deposit configurations for a workpiece have been programmed, the operator initiates the generation of a data set comprising instructions for how the apparatus should move over the workpiece in order to place the deposits in the right positions on the workpiece, and instructions for how to operate the hardware in order expel the viscous medium from the apparatus to form the deposits.

The instructions for operating the apparatus generally need to be adapted to the type of viscous medium, specific requirements from the user, mechanical variations between individual apparatuses, environmental parameters such as for example temperature, etcetera. Presently, such control instructions are stored in a static database that is the result of manual testing, evaluation and tuning. This is known to be a rather time consuming process requiring involvement from the provider's R&D staff. Therefore, it is desirable to provide an improved and more flexible technology for generating instructions for controlling the apparatus and hence the forming of the deposits of viscous medium on the workpiece.

### SUMMARY

An object of the technology disclosed is to provide an improved generation of control instructions for operating an apparatus forming a deposit of viscous medium on a workpiece.

This and other objects of the technology disclosed are achieved by means of a method according to a first aspect, in which a first parameter affecting the forming of the deposit of the viscous medium is obtained, a second parameter indicating a characteristic of the deposit to be formed by the viscous medium is obtained, and in which the first and second parameters are processed through neural network to generate control instructions for use when operating the apparatus to form the deposit.

According to a second aspect, a method for generating a trained neural network model for operating an apparatus forming a deposit of viscous medium is disclosed. The method may be understood as a scheme employing machine learning to build a mathematical model of sample data in order to make predictions or decisions without being explicitly programmed to perform the task. The model may be trained by operating the apparatus to form a deposit, measuring physical characteristics of the deposit, and recording the control instructions used when operating the apparatus to form the deposit, and environmental parameter affecting the forming of the deposit, and a deposit parameter indicating the physical characteristic of the deposit to be formed by the viscus medium, as input to the model. The measured physical characteristic and the recorded input may be used as sample data to train the model.

According to a third aspect, a system is provided, comprising an apparatus for forming a deposit of viscous medium, and a processing means, which may be implemented as a processing circuitry, configured to generate control instructions for operating the apparatus. The processing means may be configured to receive an environmental parameter affecting the forming of the deposit, to receive a deposit parameter indicating a physical characteristic of the deposit to be formed by the viscous medium, and to process the environmental parameter and the deposit parameter through a neural network to generate the control instructions for operating the apparatus.

In further examples, the system may comprise an inspection tool, such as an Automated Optical Inspection, AOI, tool configured to generate data indicating one or several physical characteristics of the formed deposit. The system may further comprise a user interface through which an operator may input and extract data for monitoring and/or controlling the methods described in connection with the above aspects.

The concept described herein is based on the idea to employ neural network technology (also referred to as artificial intelligence, Al, or machine learning) as a tool to improve the generation of the control instructions and provide an increased flexibility of the apparatus. The present disclosure allows for a more dynamic and efficient optimisation of the control instructions, since they may be generated for example on a workpiece to workpiece basis, every time a new type or batch of viscous medium is introduced, or whenever the user wishes so. Without using the neural network technology, the optimisation and generation of control instructions would require a substantial work effort by R&D engineers and test engineers. The neural network technology thus enables a considerably improved efficiency and flexibility.

The neural network model can be trained by randomly trying different combinations of parameters, such as deposit parameters and/or combinations of control instructions, during a calibration procedure and perform iterations in search of a desired solution. During this process, data indicating physical characteristics of the deposit may be generated and used to predict deposit results without having to form an actual deposit. This knowledge may be used to fine tune a final model in order to select a parameter or characteristic to optimise. The results may for example be stored in a database at the provider of the apparatus or neural network model.

According to some examples, the method may employ the neural network in a direct and/or an indirect sense. In a direct use, the environmental parameter and the deposit parameter may be input to the neural network, which delivers a set of control parameters that can be used for operating the apparatus. In an indirect use, the same set of input parameters may be used, but this case a search algorithm may be employed to find control instructions that satisfy the deposit parameter. The neural network may still be used, though, for predicting the result from the control instructions and the environmental parameters as described in the following. A first set of control instructions may be provided, for example as the result of a randomisation procedure or from a previous operation of the apparatus, and together with the environmental parameter and the deposit parameter be fed to the neural network for evaluation. The neural network may then predict a result based on the first set of control instructions, which is a theoretical result not involving the formation of an actual deposit. The predicted result may then be evaluated and used for adjusting the control parameters before they are input to the neural network once again. This procedure may be repeated until the predicted result fulfils a predetermined condition, which for example may be defined by a set of optimisation parameters, and result in the generation of control instructions that can be used for operating the apparatus to form an actual deposit.

The model may be fed with training data at the user's site by using an external measurement equipment, such as for example a solder paste inspection, SPI, tool, and/or an internal tool that is integrated in the apparatus. The data generated by the inspection tool may be used to train the neural network model to improve the operation of an individual apparatus, to create control instructions for a specific type of viscous medium, to compensate for e.g. ageing effects of the viscous medium, environmental parameters, etcetera. Additionally, or alternatively, sensors measuring for example temperature, pressure or viscosity may be employed to generate input for improving or modifying the generation of the control instructions.

A sensor may be employed to measure an environmental parameter, and/or to monitor a change of the environmental parameter over time. In case the environmental parameter changes relatively slowly in relation to the time it takes to process a single workpiece, such that the environmental parameter is substantially the same during the processing the workpiece, the parameter may be considered as a constant parameter. The sensor may also be used to monitor other parameters, such as for example hardware parameters, which also may vary or be substantially constant during the processing of the workpiece.

The present concept further allows for new types of viscous medium to be qualified at the customer's site. This may for example be achieved by allowing the user to run a test program, in which deposits are formed, evaluated and the result used as training data for the model. In some examples, the resulting model may be sent to the provider of the apparatus for further refinement or reuse at other customer sites. This also allows for the user's model to be regularly updated and thus improved and more stable over time.

The use of the neural network technology also allows for the apparatus or system to automatically update and calibrate itself, without having to involve the operator and/or the provider of the system. The neural network model may for example be regularly or even continuously updated during operation, using data from the inspection of the resulting deposits as training data. This allows for an improved process of forming the deposits, in particular in terms of repeatability and reliability, since the control instructions may be adjusted to compensate for variations between for example different batches of viscous medium and apparatuses, and for varying environmental parameters such as e.g. temperature, air humidity and pressure.

In the context of the present application, it is to be noted that the term "viscous medium" may be understood as a medium comprising e.g., solder paste, solder flux, adhesive, conductive adhesive, or any other kind of medium or fluid used for fastening components on a substrate, conductive ink, resistive paste, or the like. For at least some solder paste applications, the solder paste may include between about 40% and about 60% by volume of solder balls. The remaining volume may be solder flux.

The viscous medium may be subject to considerably varying shear rates during the process of forming the deposits. As a result, different rheological regimes may apply during different stages of the process. From one point of view, it is advantageous if the viscous medium is shear thinning at relatively low shear rates, such as e.g. below 100 s⁻¹, to facilitate for example pumping and feeding the viscous medium. From another point of view, it is advantageous if the viscous medium is shear thickening at relatively high shear rates, such as e.g. above 10.000 s⁻¹, to promote the formation of droplets propagating towards the workpiece and reduce the risk for deformation or spraying.

The viscous behaviour, also referred to as rheological behaviour, may thus be affected by the conditions to which the medium is exposed during handling of the medium and forming of the deposit. The viscosity may for example be determined or at least affected by the movement of the impacting device (and thus the varying shear rate) that in some examples may be used for ejecting the viscous medium onto the workpiece. The rheological behaviour of the viscous medium may in particular depend on e.g. the strength of the impact, the acceleration and the length of the stroke of the impacting device. By varying one or several of these parameters of the movement, the rheological behaviour (such as e.g. viscosity) may be varied accordingly. Increasing the speed and/or acceleration of the movement may e.g. result in a reduced viscosity (or shear thinning) of the viscous medium, whereas a reduced speed and/or acceleration may lead to a higher viscosity. The viscosity of the viscous medium during the forming of the deposit may affect speed and shape of the ejected droplet travelling towards the workpiece, and further influence the spreading of the viscous medium upon the impact on the workpiece.

Thixotropy is another factor that affects the process of forming the deposit. Thixotropy may be understood as a time-dependent shear thinning or shear thickening property. The rheological behaviour may hence be considered to have a 'memory', in which previous rheological states and shearing states are memorized into the viscous medium for a certain period of time. As a result, the rheological behaviour during ejection of a droplet may differ depending on previous events and previously ejected droplets. If the viscous medium previously was subjected to a relatively high shear rate, the resulting viscosity may for example be lower than if the viscous medium previously has been subjected to a relatively low shear rate instead.

A "workpiece" may be a board (e.g., a printed circuit board (PCB)), a flexible PCB or a printed wiring board (PWB), a substrate for ball grid arrays (BGA), a flexible substrate (e.g., paper), chip scale packages (CSP), quad flat packages (QFP), wafers, flip-chips, or the like.

The term first parameter may also be referred to as an "environmental parameter". Such a parameter may include factors having an impact on the forming of the deposits, and may for example relate to rheological behaviour of the viscous medium. Temperature is an example of an environmental parameter which may have an effect on the viscosity and thus the forming of the deposit as the viscous medium impacts on the workpiece. Lowering the temperature may for example lead to an increased viscosity, wherein increasing the temperature may result in a reduced viscosity. The temperature may for example refer to the ambient temperature, which may have an impact on the temperature of the viscous medium on the workpiece, and the temperature of the viscous medium itself. The latter may for example affect the transport of the viscous medium in the apparatus, the ejection of the viscous medium through a nozzle of the apparatus, and the spreading on the workpiece. A reduced ambient temperature may for example result in a reduced footprint on the workpiece, and/or a reduced volume of the viscous medium on the workpiece.

The temperature may also refer to the temperature in the apparatus, for example in regions of the apparatus in which the viscous medium is transported. In an example, the temperature may refer to a temperature in a feeding channel for the viscous medium, or in a nozzle or chamber through which the viscous medium may pass on its way towards the workpiece.

The environmental parameter may in some examples include a temperature of the electronics controlling the operation of the apparatus. The temperature of the electronics may affect the controlling, for instance the current delivered by the electronics, and may thus have an effect on the ejection of the viscous medium.

Humidity and pressure are other examples of environmental parameters, wherein an increased humidity may increase the water content of the viscous medium and thus affect its rheological behaviour.

An example of pressure includes a pressure of a pneumatic system in the apparatus, which may be used to operate the apparatus. The pneumatic system may for example be used for feeding the viscous medium to a nozzle of the apparatus, wherein an increased feeding pressure may result in more viscous medium being fed to the nozzle and eventually deposited on the workpiece. Another example of pressure includes ambient pressure, or atmospheric pressure, which may affect the operation of the above pneumatic system.

In case the apparatus comprises a nozzle through which the viscous medium is ejected towards the workpiece, the apparatus may further comprise an orifice that is aligned with the nozzle outlet so as to allow the viscous medium to pass through the orifice on its way towards the workpiece. The orifice may help improve the quality of the ejected amount of viscous medium, to reduce spraying, and further to allow a suction flow to enter the space between the orifice and the underside of the nozzle. As a result, the viscous medium may experience a headwind, opposing the forward motion of the viscous medium travelling towards the workpiece. The suction flow may be employed to catch and transport away small droplets, debris and viscous medium residues that may be generated during the ejection and which otherwise risk to form defects such as for example satellites on the workpiece. The suction flow may thus be referred to as an environmental parameter affecting the forming of the deposits, and may further be affected by the pressure in the pneumatic system of the apparatus and also by the ambient pressure in which the apparatus operates.

As already mentioned, the environmental parameter may be provided by means of a sensor, from a previously stored value (such as a database or a lookup-table), and/or be manually input by an operator.

For the purpose of this application, it is to be noted that the second parameter, which also may be referred to as a "deposit parameter", may be interpreted as a parameter describing the deposit in terms of a desired physical characteristics, such as a target size, shape or quality of the resulting deposit formed on the workpiece. Examples of physical characteristics include a width, diameter or footprint of the deposit, a height as measured from a surface or the workpiece, a target location on the workpiece, shape in terms of e.g. circularity, volume, etc., and the amount of spraying of the viscous medium. These physical characteristics may be quantified by, or associated with, a respective deposit parameter.

According to some embodiments, the hardware parameters may be used as input to the neural network. Hardware input may for instance relate to mechanical characteristics of the apparatus, such as mechanical tolerances affecting the forming of the deposit and the positioning of the same. In case the apparatus comprises an ejector, which will be described in the following, the hardware parameters may describe mechanical or operational characteristics of the nozzle, the actuating arrangement or the feeding mechanism. This allows for the neural network to take hardware specific variations into consideration when generating the control instructions and thereby make it possible to compensate for effects stemming from for instance varying nozzle sizes, actuating forces, and pump efficiencies.

Hardware parameters may also refer to characteristics related to for example an XY-positioning system of the apparatus, affecting the positioning of the deposit relative the workpiece, or to characteristics of the workpiece itself. In case the apparatus is associated with a known and systematic positioning error relative the workpiece, the control instructions may be adapted accordingly so as to compensate for this error. Similarly, the control instructions can be adjusted based on for example a known curvature or surface-spreading characteristics of the workpiece in order to further improve the quality of the deposit. The hardware parameter may in some examples be provided by means of a sensor, which for example may be employed to measure an actual performance or mechanical characteristics of the apparatus, or a physical characteristics of the workpiece.

The process of forming a deposit on a workpiece typically involves an apparatus capable of selectively placing the viscous medium on desired locations on the workpiece. Such an apparatus may be referred to as an ejector, which in some examples may comprise an actuating arrangement that is operable to force an amount of viscous medium through a nozzle and towards a surface of the workpiece.

In some examples, the apparatus is a surface mount technology, SMT, tool and the viscous medium a SMT medium used for mounting SMT electrical components on the workpiece. Such an apparatus may be a jet printer or jet dispense, comprising an ejector as described above. Alternatively, the apparatus is a dispenser, such as for example a contact dispenser. Preferably, the SMT tool may be configured to form deposits of for instance solder paste, adhesive or underfill.

The process for ejecting or shooting droplets of viscous medium onto a surface of the workpiece to form a deposit may be referred to as "jetting". The jetting may be performed while the jetting nozzle is in motion without stopping at each location on the workpiece where viscous medium is to be deposited.

The term "jetted droplet", or "shot" should be understood as the volume of the viscous medium that is forced through the jetting nozzle and moving towards the substrate in response to an impact of the impacting device. It will however be appreciated that a plurality of droplets may be expelled from the nozzle in response to a single stroke of the impacting device.

As discussed herein, the term "deposit size" refers to the area on the workpiece, such as a substrate, that a deposit will cover. An increase in the droplet volume generally results in an increase in the deposit height as well as the deposit size.

An ejector generally comprises a chamber for accommodating a volume of the viscous medium prior to the jetting thereof, a jetting nozzle communicating with the nozzle space, and an impacting device for impacting and jetting the viscous medium from the chamber through the nozzle in the form of droplets. Further, a feeder may be utilised to feed the medium into the nozzle space. The amount, or volume, of the deposited viscous medium at different locations on the substrate may be varied by applying several droplets on top of each other, thus forming a larger deposit, or by varying the volume of the jetted droplet by e.g. feeding a larger or smaller volume of the viscous medium into the chamber.

Such an apparatus is typically software-controlled. The software requires instructions for how to eject a given viscous medium onto a given workpiece according to a specific sequence or pattern. These instructions may be referred to as control instructions. Thus, the control instructions may instruct the apparatus and support the process of ejecting viscous medium onto the workpiece. This process may also be referred to as a jetting process' or 'printing process'. The control instructions may be generated by a pre-processing step performed offline, prior to the process of forming the deposits. The control instructions may also be generated continuously during the process of forming the deposits. The apparatus may comprise a control unit, or be part of a system comprising a control unit, wherein the control unit is configured to control for example the actuator arrangement according to the control instructions. Further, the control unit may be capable of providing the control instructions. It is also envisioned that the control instructions may be fed to the actuator arrangement via a remote processing unit not being part of the apparatus, or via a cloud interface.

The obtained control instructions may be configured to control an actuating force by which the actuator arrangement ejects the viscous medium droplet. The actuating force may affect for example exit velocity of the viscous medium, the shear thinning of the viscous medium, or the actual volume ejected from the ejector. The choice of actuating force may be based on several different factors, some of which relating to the current rheological state of the viscous medium in the ejector, the available amount of viscous medium that can be formed into an ejected droplet, a target volume of the droplet, and a target footprint of the resulting deposit on the workpiece. Examples and effects of possible actuating forces will be discussed in the following.

The obtained control instructions may for example be configured to reduce the actuating force compared to the actuating force used for ejecting a previous droplet. This may be an advantage if the droplet is ejected relative shortly after the previous droplet, i.e. if it can be assumed that there is not time enough for the shear thinning that was induced during ejection of the previous droplet to be restored. In other words, if the time period is sufficiently long to allow the viscous medium to maintain, or 'remember', its reduced viscosity, it might be advantageous to adjust the actuating force accordingly. It may also be an advantage to reduce the actuating force if the volume of previous droplet was larger, i.e., if the target size of the droplet to be ejected is smaller than the actual volume of the previous droplet. The change in droplet volume may in some examples be implemented by changing the actuating force, such that a reduced impact results in a reduced ejected amount of viscous medium.

The control instructions may in some examples be configured to control a feeding rate at which the viscous medium is supplied to the ejector. The feeding may for example be realised by means of a feeder mechanism, which may be operated according to the control instructions. The feeding rate may be controlled so as to control the amount of viscous medium that is available for the ejection of the droplet, for example in a chamber arranged between the impact device and the nozzle. The feeding rate may also influence the viscosity of the viscous medium, as the feeding typically subjects the viscous medium to shearing. In one example, the control instructions may be configured to reduce the feeding rate compared to the feeding rate used when ejecting a previous droplet in a sequence. The feeding rate may be reduced in order to provide a droplet of a smaller volume. In another example, the obtained control instructions may be configured to increase the feeding rate compared to the feeding rate used when ejecting a previous droplet. The increased feeding rate may result in a droplet having an increased volume compared to the previous droplet.

In some examples, the feeding or pumping may be initiated at the beginning or start-up of an ejection sequence. This is of particular interest in case the viscous medium already present in the ejector otherwise tends to have an initial viscosity that differs from the viscosity of the viscous medium that is being fed to the jetting chamber during the ejection sequence. By subjecting the viscous medium in the ejector to shearing before the ejection sequence is started, that is, before the first droplets are ejected onto the substrate, the viscous medium may be given a viscosity that is closer a steady state viscosity of a continuous ejection sequence.

In some examples, the control instructions may be configured to affect a temperature of the viscous medium. The temperature may for example be controlled by means of a heating or cooling element arranged in thermal contact with the viscous medium to be ejected, for example at the nozzle. The temperature may affect the viscosity of the viscous medium, such that the viscosity for example is reduced when the temperature is increased.

The actuator arrangement may comprise for example a piezoelectric actuator. The actuator arrangement may further comprise an impacting device for rapidly building up pressure in a chamber of the ejector by rapid movement (e.g., rapidly controlled mechanical movement) of the impacting device (e.g., the rapid movement of a plunger) over a period of time that may be longer than about a tenth of a microsecond, but, in some examples, less than about 50 microseconds, thereby providing a deformation of the medium in the chamber that forces droplets of viscous medium through a nozzle. In one implementation, the control instructions are configured to apply a voltage intermittently to a piezoelectric actuator, thereby causing an intermittent extension thereof, and a reciprocating movement of the impacting device, such as a plunger or with respect to an assembly housing of the ejector. The step of actuating the impact arrangement may comprise controlling at least one of a voltage rise time, a voltage fall-time, a voltage plateau time, and a peak voltage value applied to the impact arrangement. The actuation profile may in some examples be of a trapezoidal form, or a functionalized (such as polynominal or trigonometric) form.

Examples of neural networks include artificial neural networks, probabilistic graphical models such as Bayesian networks, probabilistic classifiers and/or controllers (e.g. Gaussian mixture models). As one example, the neural network can be an artificial neural network having at least one internal layer of nodes (often referred to as a hidden layer of neurons) that apply one or more weights, biases, and/or transfer functions to input data comprising the environmental parameter and the deposit parameter to correlate the input data to output data comprising the control instructions. Examples of artificial neural networks include recurrent neural networks (RNN), gated recurrent units (GRUs), long short-term memory (LSTIM) architectures and attention nets.

According to an embodiment, the environmental parameter is selected from the group consisting of: ambient pressure, temperature of the viscous medium, air humidity, pressure applied to the viscous medium, and rheological characteristics of the viscous medium. The model for generating the control parameters may hence take at least some of the above factors into consideration in order to provide a deposit having certain characteristics. The model may for example adjust the control parameters depending on the type of viscous medium that is to be jetted, at least in terms its viscosity, and further depending on for example the ambient temperature in which the apparatus operates. The environmental parameter may for example be obtained from a sensor, such as a temperature sensor, a pressure sensor, or an equipment for measuring rheology. The sensor may in some examples be integrated in the apparatus, and in other examples be provided as a unit that is separate from the apparatus. Further, the sensor may be configured to retrieve data indicating the environmental parameter in connection with the environmental parameter being inputted to the neural network, or in advance, for example from a prior or separate measurement. In one example, the environmental parameter may be based on a previous rheological measurement, for example performed at a separate occasion in a laboratory or separate measuring equipment. Alternatively, or additionally, the environmental parameter is obtained from an operator inputting the environmental parameter via a user interface.

According to an embodiment, the deposit parameter may indicate a physical characteristic selected from the group consisting of a width of the deposit, a height of the deposit, a volume of the deposit, a position of the deposit on the workpiece, and a maximum spraying of the viscous medium. This allows for the operator to decide for which parameter the model should be optimised. In cases wherein the volume is a more critical parameter than the positioning, the model can be instructed to optimise for the volume at the cost of positioning accuracy, and vice versa. Advantageously, the deposit parameter may be configured to lie within a specific range indicating an accuracy interval which is acceptable. In other words, the operator may instruct the model to optimise the result until a measured deposit parameter lies within a certain tolerance range, such as for example a positioning error interval, a volume deviation range, or between a maximum and a minimum deposit diameter.

According to some embodiments, the deposit parameter may be obtained from a database, or from an operator inputting the deposit parameter via a user interface. The database may for example comprise information associating an electric component or package type with specific deposit parameters. In one example, a ball grid array, BGA component may result in a set of deposit parameters that are specific for the actual BGA component (e.g. relating to position accuracy and spraying constraints), whereas a two-terminal resistor may result in another set of deposit parameters (e.g. relating to volume accuracy and shape constraints).

According to an embodiment, the control instructions may be configured to operate an actuator arrangement for ejecting the viscous medium in the apparatus, a feeder mechanism for supplying the viscous medium to a nozzle of the apparatus, a temperature of the viscous medium in the apparatus, and/or a means controlling the distance between the nozzle and a surface of the workpiece.

According to an embodiment, the deposit parameter and/or the environmental parameter may be monitored during the operation of the apparatus, and the control instructions dynamically updated based on the monitored deposit parameter and/or environmental parameter during the operation. Thus, the process quality may be dynamically monitored and adjusted in order to provide deposits lying within a predetermined accuracy and/or quality range.

According to an embodiment, the method may be performed in a calibration process, wherein the generated control instruction may be stored in a database for subsequent use during production. The database may be employed to provide control instructions for a later occasion, and further to share the data with other apparatuses and/or production facilities. The database may for example be stored in a cloud-based context.

In an embodiment, the control instruction may be stored in a database associating the control instructions with information relating to the type of viscous medium. Hence, each type of viscous medium may have a related set of control instructions which can be loaded into the apparatus and used for forming deposits of the medium.

As previously mentioned, the method for generating a trained neural network model may include the steps of:
a) operating the apparatus to form a deposit,
b) measuring a physical characteristic of the formed deposit,
c) recording the control instruction used to form the deposit, the environmental parameter(s) affecting the forming, and a deposit parameter indicating a desired or target physical parameter of the deposit as input data to the model, and
d) using the measured physical characteristic and recorded input data to update the parameters in the model.

According to an embodiment, the above steps may be repeated until the difference between the deposit parameter and the measured physical parameter of the actual deposit formed in step a) is within a predetermined interval. The method may for example be repeated until the volume of the formed deposits has converged to a target volume and a target deviation.

According to some embodiments, a system is provided comprising an apparatus for forming a deposit of viscous medium on a workpiece as described above, and a processing means configured to process the environmental parameter and the deposit parameter through the neural network to generate the control instructions. Further, an inspection tool, such as an Automated Optical Inspection, AOI, tool may be provided, either as a part of the system or as an external part providing input data to the processing means. The inspection tool may be configured to generate data indicating physical characteristics of an actual deposit previously formed by the apparatus. The data may for example contain information relating to diameter, shape, volume and/or number of satellites associated with the deposit.

The data from the inspection tool may be delivered to the processing means and used as input for training the neural network model.

The nodes of such a system may be communicating with each other either by wire or wirelessly. In some examples, one or several parts of the system may be utilising a cloud technology, in which data may be sent to, received from and/or stored in a cloud based database. Such a database may for example store the neural network model, and may be shared with one or several other users.

### BRIEF DESCRIPTION OF THE DRAWINGS

The above, as well as additional object objectives, features and advantages of the present concept will be better understood through the following illustrative and non-limiting detailed description of different embodiment of the present concept, with reference to the appended drawings, on which:
Figure 1 is a cross section of an apparatus according to an embodiment;
Figure 2 is a schematic representation of a system according to an embodiment;
Figures 3a-c are schematic illustrations of some embodiments;
Figure 4 is a flow chart illustrating a calibration procedure according to an embodiment; and
Figures 5-7 are flow charts of processes according to some embodiments;

The figures are not necessarily to scale, and generally only show parts that are necessary in order to elucidate the concept disclosed herein, wherein other part may be omitted or merely suggested.

### DETAILED DESCRIPTION OF EMBODIMENTS

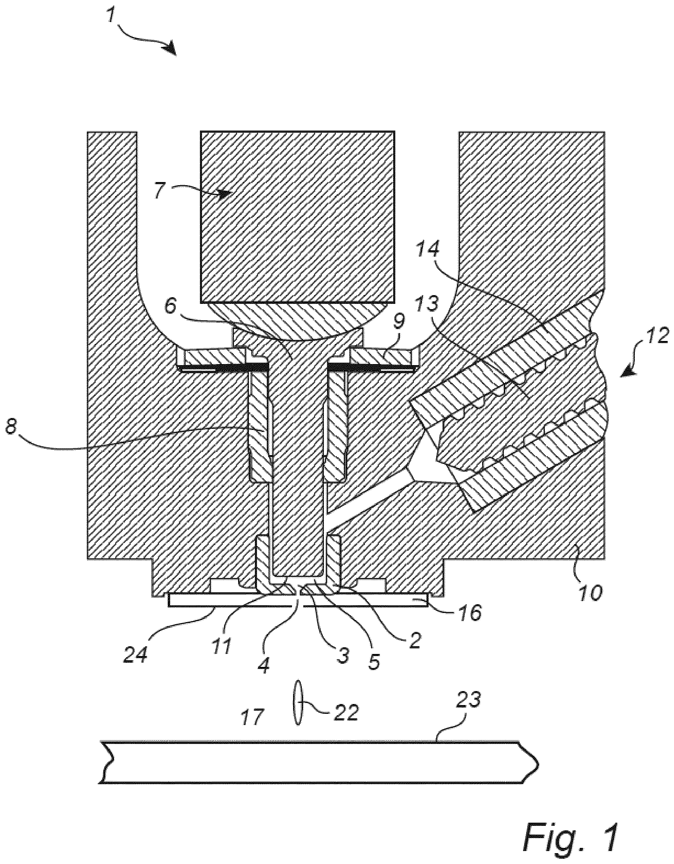

With reference to figure 1, there is shown a schematic view of an apparatus according to an implementation of the technology described. The apparatus may comprise an ejector 1 comprising an assembly housing 10 and an impacting device, which in this implementation may include a piezoelectric actuator 7 and a plunger or piston 6 operatively connected to the piezoelectric actuator 7. The plunger 6 may be axially moveable while slideably extending through a bore hole in a bushing 8. Cup springs 9 may be provided to resiliently balance the plunger 6 against the assembly housing 10, and for providing a preload for the piezoelectric actuator 7. A control unit (not shown) may apply a drive voltage intermittently to the piezoelectric actuator 7, thereby causing an intermittent extension thereof, and hence a reciprocating movement of the plunger 6 with respect to the assembly housing 10, in accordance with control instructions generated by processing an environmental parameter affecting a rheological behaviour of the viscous medium, and a deposit parameter indicating a physical characteristics of the deposit to be formed, through a neural network.

Furthermore, the ejector 1 may comprise jetting nozzle 2, which may be operatively directed against a workpiece 23 onto which droplets 22 of viscous medium are to be jetted. The workpiece 23 may for example be a substrate such as printed circuit board, PCB. The nozzle 2 may according to the present embodiment comprise a nozzle space 3 and a nozzle outlet 4 through which the droplets 22 are jetted towards the substrate 23. The nozzle outlet 4 may be located at one end, such as a lower portion, of the nozzle 2.

A chamber 5 may be defined between an end surface 11 of the plunger 6 and the nozzle 2. Axial movement of the plunger 6 towards the nozzle 2 may cause a rapid decrease in the volume of the chamber 5. Such an impact by the plunger 6 may thus cause a rapid pressurisation and jetting of viscous medium through the nozzle outlet 4.

In other implementations of the technology disclosed using a different type of ejector, the plunger comprising a piston may be replaced by another type of impacting device such as e.g. a membrane or diaphragm.

All these impacting devices have in common that they are configured to provide for a non-contact jetting process to form and shoot droplets of a viscous medium from a jetting nozzle onto a substrate by quickly generating a pressure impulse by the reciprocating, or vibrating movement of the impacting device based on control instructions.

The impacting devices may move from a starting position towards an end position during a time period of about 1 to 50 microseconds in order to shoot individual droplets having a deposit volume between about 0.1 nanolitres and 30 nanolitres, such as e.g. 1 to 5 nanolitres, 5 to 15 nanolitres or 10 to 20 nanolitres. The speed of the impacting device for impacting the nozzle with a pressure impulse may be between about 5 m/s and about 50 m/s.

Further, the ejector 1 may comprise a washer 24 arranged downstream of the nozzle 2 and comprising an orifice that is aligned with the nozzle outlet 4 so as to allow the jetted viscous medium to pass through the orifice on its way towards the workpiece. The space defined between the washer 24 and the nozzle 2 may be fluidly connected to a pump unit to allow a suction flow to enter the space through the orifice. As a result, the viscous medium may experience a headwind, opposing the forward motion of the viscous medium travelling towards the workpiece. The suction flow may be employed to catch and transport away small droplets, debris and viscous medium residues that may be generated during the jetting process and which otherwise risk to form defects such as for example satellites on the workpiece.

Viscous medium may be supplied to the nozzle space 3 from a supply container (not shown in figure 1), via the feeding channel of a feeder 12. The feeder 12 may comprise an electric motor (not shown) having a motor shaft 13 partly provided in a tubular bore that extends through the ejector housing 10 to an outlet port communicating with the chamber 5 via a channel. At least a portion of the rotatable motor shaft, or feed screw 13 may be surrounded by a tube 14 made of an elastomer or the like arranged coaxially therewith in the tubular bore, wherein the threads of the rotatable feed screw 13 may be in sliding contact with the innermost surface of the tube. Viscous medium captured between the threads of the feed screw 13 and the inner surface may then be forced towards the chamber 5 in accordance with the rotational movement of the feed screw 13.

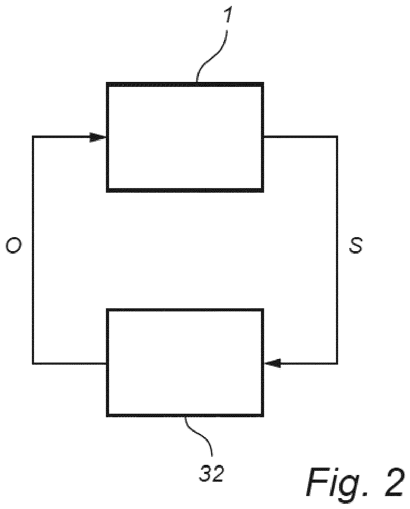

Figure 2 is a schematic representation of a system according to an embodiment of the present concept. The system may comprise an apparatus 1 for forming a deposit according to any of the above described embodiments, and a control unit 32 (also referred to as processing circuitry) configured to provide the control instructions for operating the apparatus. The apparatus may further comprise an inspection tool (not shown) that is configured to output a sensor signal S indicative of a physical characteristics, such as for example position or size, of the formed deposit. The sensor signal S may be transmitted to the control unit 32, wherein it may be used to train the neural network model to generate modified control instructions for operating the apparatus 1. The control instructions may be output from the control unit 32 in the form of a control signal O and transmitted to the apparatus 1. Thus, the inspection data from the deposit may be used in a closed-loop manner for adjusting the operation of the apparatus.

The present concept may be used in connection with surface mount technology, SMT, production. More particularly, the apparatus may be configured to form deposits of solder paste or adhesive used when mounting electrical components on a PCB. For this purpose, the apparatus may comprise an ejector as described above.

The operation of the ejector may be described as a statistical process that can make the application of solder paste and other SMT media unstable. This may result in variations in the applied volume, the precision of positioning, etcetera. In prior art technology, a model describing the parameters controlling the jetting may be developed manually in a rather time consuming process in which for example the shape of the electrical pulse controlling movement of the actuating arrangement, such as the piezo, is determined. Other parameters may relate to the control of the supply of viscous medium, which for example may be achieved by means of a screw pump and/or a pressure applied to the container storing the viscous medium. Further examples of parameters may include temperature of the viscous medium, which is known to affect the viscosity. Typically, the model is the result of a trade-off between different user requirements. Some users require high positioning precision, whereas other require high volume precision. Quite often those requirements are not fully compatible, meaning that an increased positioning precision may lead to a reduced volume precision and vice versa.

These issues may be addressed by using a variant of reinforcement learning and trying to model the behaviour of the ejector. One solution may be to train a model by giving all control parameters (such as pump parameters, piezo waveform) together with environmental parameters like ambient temperature and pressure. The ambient temperature is known to affect the rheology of the viscous medium in that for example a lower temperature may increase the viscosity. As a result, the waveform of the signal controlling the movement of the actuator (in this example a piezo actuator) needs to be modified to as to correct the speed of the ejected droplet(s). The lowered temperature may also affect the pump behaviour (in the present example a screw pump). The output of the model may be the predicted deposit diameter and volume, together with information about how sure the model is of the prediction, e.g. on a scale between 0 (unsure) and 1 (very sure).

A first, illustrative and exemplary case will now be described. In a first step, the user may create a job, i.e., a program or sequence of steps defining a process in which one or several deposits are formed on a substrate. The job may comprise information about where the solder paste or adhesive should be placed and for which characteristics the model should be optimised. The model may for example be optimised in respect of volume stability, positioning, shape or footprint. The optimisation may be deposit specific, such that some deposits (such as single dots for BGA components) need to be optimised for positioning to prevent bridges and shortcuts, while other deposits need to be optimised to give an as correct volume as possible. The present concept allows for a search for the best parameters to get a scheme of control parameters for this specific job.

In a second step, the apparatus starts depositing using this scheme. Measurement may be performed during the dispositioning process, e.g. of suction flow that may be used to keep the ejector clean from accumulated solder paste, and temperature in different parts of the ejector. Should the suction flow sink below a predetermined threshold, this may indicate that viscous medium has been accumulated at the nozzle outlet and is potentially blocking the way of the expelled viscous medium. If so, the model can compensate for this by altering the waveform to give the viscous medium a higher speed allowing it to pass through the accumulated and potentially blocking viscous medium, or by adjusting the suction flow in order to reduce the risk for accumulation of viscous medium at the nozzle.

In a second example, the problem of different rheological behaviour between different batches may be addressed. The flux has turned out to be a challenge when handling solder paste - in particular for solder paste types using flux of an organic nature. As a result, there is a risk that control instructions that work well for one batch of solder paste will not give as good results for the next batch, depending on different rheological characteristics between the batches. The present concept therefore suggests a training program to be initiated, in which the apparatus forms a deposit, measure its physical characteristics, and calculates calibration parameters for the specific solder paste batch. The calibration parameters may then be fed to the model to compensate for the batch-specific variations in the solder paste to further improve the result. This allows for the user to achieve a more even quality of the application of solder paste or other types of viscous media.

A third example is concerned with the problem of qualifying new types of viscous media. This may be relevant with the user needs to use a special type of medium having not yet known characteristics. The user can then try to use other, existing models that are adapted to known types of viscous medium, to find out which one of the models that seems to work best. When the best one of the models is found, the user may use that to generate a new model based on the previous one. The apparatus may then form a deposit, inspect the result and update the model step by step until the user is satisfied with the result. When the user is satisfied, they can save the model to be used in production. This allows for a fast prototyping at the user's site, since the process does not have to involve engineers from the supplier of the apparatus.

It should be noted that the described method can be performed either by forming deposits on an actual substrate, such as PCB, or on a dedicated calibration workpiece. In some examples, the apparatus may comprise a built-in calibration workpiece that can be used for calibrating and/or verifying the control parameters before the production is initiated, during the production, and/or in a separate calibration process.

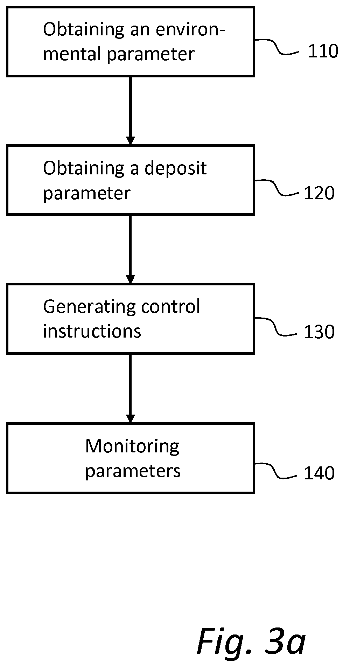

Figure 3a is a schematic outline of a method according to an embodiment, in which control instructions for operating an apparatus forming a deposit of viscous medium on a workpiece is disclosed. The apparatus, which for example may be a jetting apparatus or dispenser, may be similarly configured as the apparatus discussed above in relation to figures 1 and 2.

In the present method, one or several environmental parameters affecting the forming of the deposit may be obtained 110. The environmental parameter(s) may for example be obtained through user input via a user interface, from a sensor, or from a database storing information associating for example temperature and rheological characteristics of the viscous medium.

Further, one or several deposit parameters, indicating a physical characteristic of the deposit to be formed by the viscous medium, may be obtained 120. The physical characteristic may for example relate to a size or shape of the deposit, or to a desired position on the workpiece. Typically, a deposit parameter may be associated with a workpiece layout indicating for instance the amount, shape and position of each deposit on the workpiece. In the case of SMT applications, the deposit parameter may be associated with the type of electric component that is to be mounted on the workpiece. This is based on the realisation that different types of components may require for example different volumes and/or diameters of the solder paste (or adhesive) deposits. Components having a fine-pitch contact layout may for example require smaller deposits than components having a coarse-pitch contact layout.

The environmental parameter and the deposit parameter may be processed through a neural network to generate 130 the control instructions for use when operating the apparatus to form the deposit. The control instructions may hence instruct the apparatus and support the process of ejecting viscous medium onto the workpiece. In case the apparatus is a jet printer, comprising an ejector for jetting for instance solder paste or adhesive, or a contact dispenser, the control instructions may determine the motion of the ejector or dispensing needle over the workpiece, the feed rate of viscous medium to the nozzle, and the mechanism that accelerates the viscous medium from the nozzle towards the workpiece.

According to some embodiments, the deposit parameter and/or the environmental parameter may be monitored 140 during the operation of the apparatus. The monitored parameter(s) may be used as input in the above steps of obtaining 110 the environmental parameter and obtaining 120 the deposit parameter, respectively. In some examples, the temperature and/or viscosity of the viscous medium may be monitored during the operation. In further examples, the volume and/or shape of the formed deposits may be monitored and used as feedback to the neural network model. This allows for the control instructions to be dynamically updated during the operation of the apparatus.

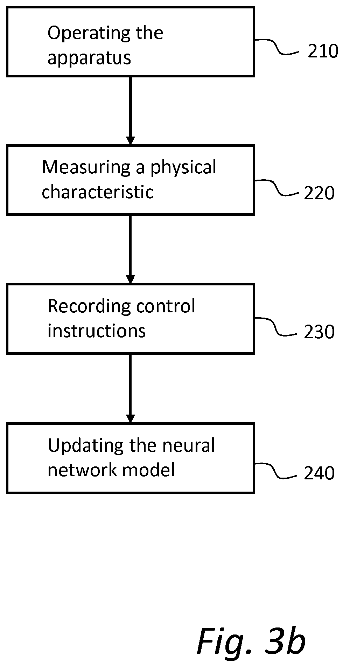

Figure 3b is a schematic outline of a method according to some embodiments, in which a trained neural network model is generated. The trained neural network model may be similarly configured as the neural network model discussed in connection with figure 3a, and may hence be used to generate control instructions for operating an apparatus in line with what has been described above.

In an example, the method may comprise operating 210 the apparatus to form a deposit, measuring 220 a physical characteristic of the deposit, and recording 230, as input to the model, one or several of: the control instructions used when operating the apparatus to form the deposit, an environmental parameter, and a deposit parameter. The measured physical characteristics and the recorded input may then be used to update 240 the neural network model. The above steps may be repeated until the difference between the deposit parameter and the measured physical characteristic is within a predetermined interval.

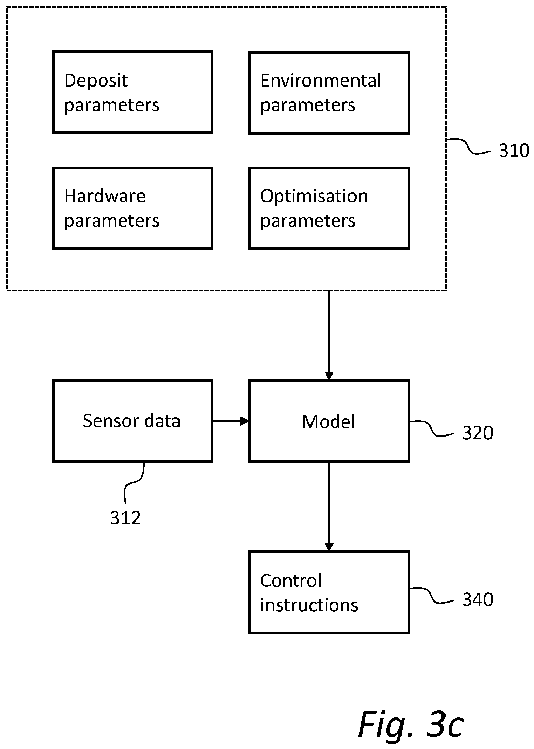

Figure 3c is a schematic illustration of an embodiment, which may be similarly configured as embodiments of figures 3a and 3b. Figure 3c illustrates examples of input data that is fed to the neural network model. As shown, the neural network 320 may employ a machine learning model that as input 310 uses for example deposit parameters, also referred to as a job description, comprising for example information pertaining to positioning and volume of the deposits. The input 310 may further comprise environmental parameters describing for example a temperature and/or rheological characteristics of the viscous medium, hardware parameters describing for example the impact strength of a piston used for ejecting the viscous medium or a pump efficiency for feeding the viscous medium to the nozzle, and/or information about which parameters that should be optimised or at least improved. Additionally, the input may comprise sensor data 312 relating to for example pressure responses in the system, temperatures, velocity of viscous medium travelling towards the substrate, etcetera. These input data 310, 312 are then processed by the machine learning model 320 to generate a set of control instructions 330 for controlling the apparatus.

In one example, the user may send a job description to the apparatus and scan a barcode on the solder paste container to retrieve information about the type of solder paste and the batch. Further, information indicating the identity of the ejector may be retrieved. Before the jetting process is initiated, information may be retrieved indicating environmental parameters such as e.g. atmospheric pressure and temperature. Next, a calibration pattern is produced and evaluated as will be described in the following. During the production, or jetting process, parameters such as temperature, pressure, sound and droplet velocity may be retrieved from various sensors, preferably prior to the ejection of each droplet. These sensor data may be used as input to determine the control instructions for the ejection of the next droplet. Thus, the control of the apparatus may be unique for each droplet that is ejected.

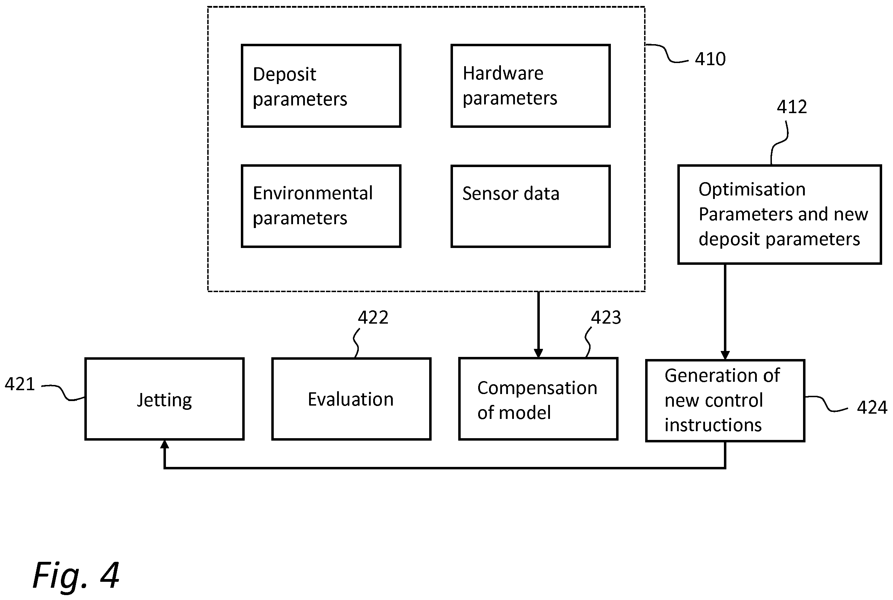

Figure 4 is a flow chart illustrating a calibration procedure of a trained neural network model (which may be similar to the neural network models according to the previous embodiments), in which viscous medium is jetted 421 on a calibration workpiece or a PCB and evaluated 422. The user may then select 412 what to optimise, such as e.g. positioning or volume. This is together with other parameters relating to e.g. the hardware, deposit parameters, sensor data and/or environmental data used as input 410 for adjusting 423 the model, which then is used to produce 424 new control instructions for the next iteration of the calibration process. This method may for example be employed by the manufacturer of the apparatus for providing a model that is trained for several different ranges of input parameters, such as for instance different environmental parameters. In case the method is used at the production facility, for instance when adjusting the model to the processing of a specific workpiece, the deposit parameters and the optimisation parameters may be known beforehand (i.e., a specific result is desired for the particular type of workpiece). In that case, the deposit parameters and the optimisation parameters may be kept constant during the iteration process illustrated in the present figure.

The neural network may use a "Deep reinforcement learning" algorithm, which may work in a similar way as the "alpha go zero" algorithm. The algorithm may however be adjusted depending on the specific application. In one example, the algorithm may be modified by replacing the Convolutional layers (used for image analysis) with embeddings and bidirectional LSTMs (or GRU). It may also need optimisation parameters as inputs to know what to optimise for (such as e.g. diameter, volume, satellite levels). The Monte Carlo tree-search algorithm may be changed to one that works in continuous action space.

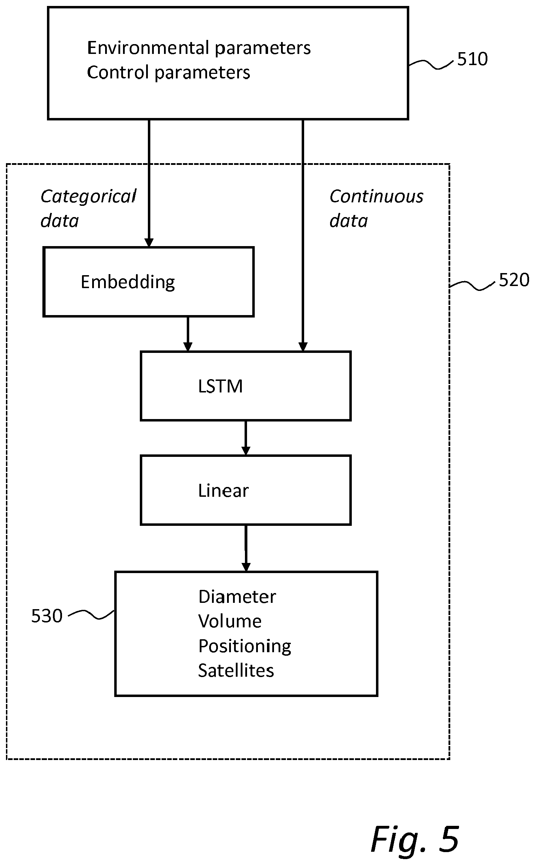

Figure 5 shows an embodiment, in which input 510 in the form of environmental parameters and a set of control parameters are input to a prediction model 520, employing a neural network model which may be similar to the ones discussed above. The input parameters may be a mix of both continuous (floating point values) and categorical (maximum of about 200 unique values). To help the model 520, the categorical data can be converted to continuous data with "embeddings" as shown in figure 5. In this example, the input 510 comprises both continuous data and categorical data, wherein the latter is converted into continuous data before transmitted to the neural network, in this example a long short-term memory (LSTM). The predicted result 530, which may be generated through a linear layer, may for example be quantified in terms of diameter, volume, positioning or amount of satellites of the formed deposit.

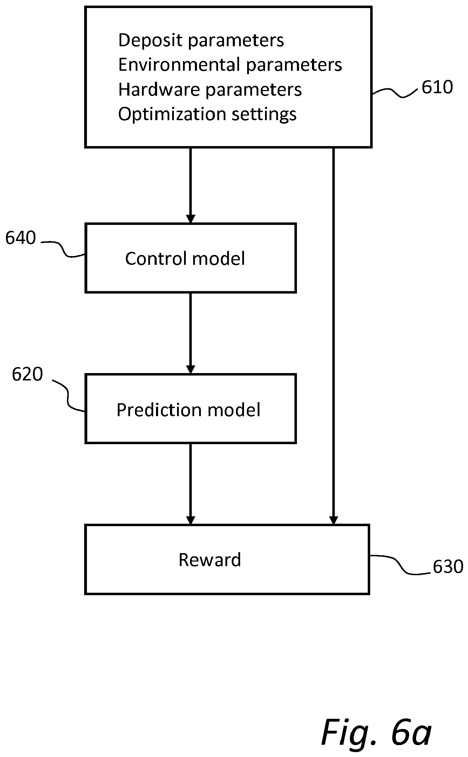

Figure 6a shows an embodiment in which input 610 in the form of for instance deposit parameters, environmental parameter, hardware parameters and/or optimisation settings are fed to a neural network model 640, also referred to as a control model, generating a first set of control instructions that can are input to a prediction model 620. The prediction model may be similarly configured as the one described in connection with figure 5. Depending on the optimisation parameters, the predicted result may be associated with a reward or a loss generated by a reward function 630. The control model may then be tuned based on the reward/loss, and the above described steps repeated until a desired result is achieved. Thus, this is an efficient way of verifying and adjusting the model generating the control instructions without having to form actual deposits for each iteration.

In an embodiment, some parameters, such as for instance deposit parameters and optimisation parameters, may be sent directly to the reward function 630 to enable a score to be generated depending on how good the prediction is compared to what is asked for (i.e., the deposit parameters).

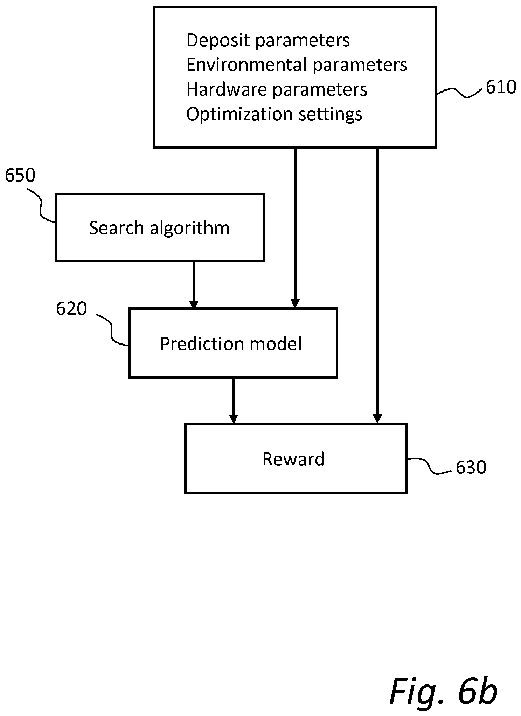

Figure 6b shows a similar embodiment as in figure 6a, with the difference that a search algorithm 650 may be employed to generate a set of control parameters, which are then fed to the prediction model 620. In this example, input parameters 610 such as for example deposit parameters and optimisation parameters (also referred to as optimisation settings) may be sent to the reward function 630, whereas and environmental parameters and hardware parameters may be sent to the prediction model 620. Preferably, the optimisation parameters may be sent both to the reward function 630 and to the prediction model 620.

The optimisation parameters may be applicable for the processing of the entire workpiece. Alternatively, they may be specific for a subset of deposits to be formed on the workpiece, or for individual deposits.

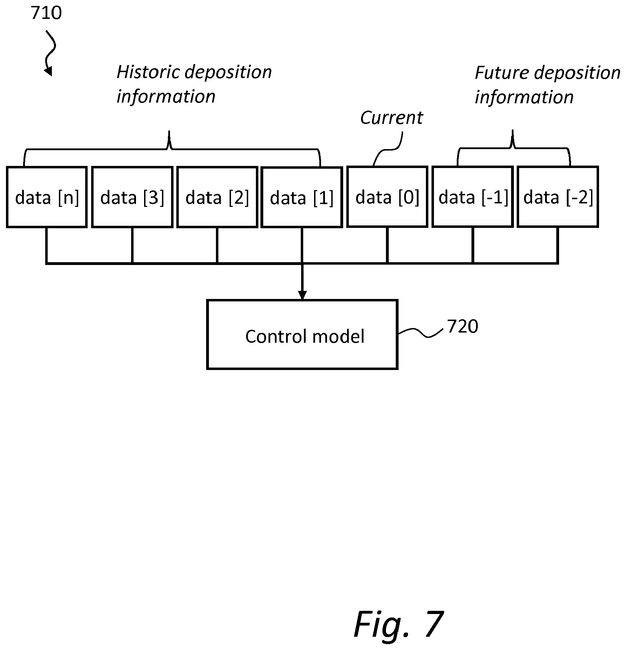

The result of the forming of the deposits may be influenced by both parameters and the history of how previous deposits have been formed. This means that the model may keep track of the history of the deposits to be able to accurately predict the next result. Figure 7 illustrates the input 710 to the control model 720, which may comprise information relating to historic deposition (data [1]-[n]), current deposition (data [0], and future deposition processes (data [-1]-[-2]). The data may be input to the control model 720, which may generated a set of control instructions as described with reference to figures 6a and 6b.

As outlined above, the method may be embodied as computer-executable instructions distributed and used in the form of a computer program product including a computer-readable medium, e.g. a tangible computer-readable medium as described below. storing such instructions. The processing circuitry may be configured to execute the instructions carried by the computer-readable medium and thereby cause an apparatus to form a deposit of the viscous medium. By way of example, computer-readable media may comprise computer storage media and communication media. As is well known to a person skilled in the art, computer storage media includes both volatile and non-volatile, removable and non-removable media implemented in any method or technology for storage of information such as computer readable instructions, data structures, program modules or other data. Computer storage media includes, but is not limited to, tangible computer storage media such as RAM, ROM, EEPROM, flash memory or other memory technology, CD-ROM, digital versatile disks (DVD) or other optical disk storage, magnetic cassettes, magnetic tape, magnetic disk storage or other magnetic storage devices. Further, it is known to the skilled person that communication media typically embodies computer readable instructions, data structures, program modules or other data in a modulated data signal such as a carrier wave or other transport mechanism and includes any information delivery media.

The concept disclosed herein has mainly been described above with reference to a few embodiments. However, as is readily appreciated by a person skilled in the art, other embodiments than the ones disclosed above are equally possible within the scope of the concept, as defined by the appended patent claims.

## Claims

1. A method for generating control instructions for operating an apparatus (1) forming a deposit of viscous medium (22) on a workpiece (23), the method comprising:
obtaining (110) an environmental parameter affecting the forming of the deposit;
obtaining (120) a deposit parameter indicating a physical characteristic of the deposit to be formed by the viscous medium;
processing the environmental parameter and the deposit parameter through a neural network to generate (130) the control instructions for use when operating the apparatus to form the deposit.

2. The method of claim 1, wherein the environmental parameter is selected from the group consisting of:
ambient temperature;
temperature of the viscous medium;
temperature of electric control circuits of the apparatus;
pressure applied to the viscous medium;
an air flow rate for cleaning a nozzle of the apparatus; and
rheological characteristics of the viscous medium.

3. The method of claim 2, wherein the environmental parameter is obtained from a sensor or from an operator inputting the environmental parameter via a user interface.

4. The method of any of the preceding claims, wherein the deposit parameter indicates a physical characteristic selected from the group consisting of:
a width of the deposit;
a height of the deposit;
a volume of the deposit; and
a position of the deposit on the workpiece.

5. The method of claim 4, wherein the deposit parameter is associated with a range indicating a target accuracy of at least one of:
the width of the deposit;
the height of the deposit;
the volume of the deposit;
the position of the deposit on the workpiece; and
a maximum probability of spraying of the viscous medium.

6. The method of claim 5, further comprising obtaining two or more deposit parameters, each associated with a respective tolerance range indicating the target accuracy for that parameter.

7. The method of any of claims 4 to 6, wherein the deposit parameter is obtained from a database, or from an operator inputting the deposit parameter via a user interface.

8. The method of claim 7, wherein the apparatus is a surface mount technology, SMT, tool for forming deposits of solder paste or adhesive for mounting of electric components, and wherein the database comprises information associating the electric components with deposit parameters.

9. The method of any of the preceding claims, wherein the control instructions are configured to operate at least one of:
an actuator arrangement for ejecting the viscous medium from the apparatus;
a feeding mechanism for supplying the viscous medium to a nozzle of the apparatus;
a temperature of the viscous medium in the apparatus; and
a means controlling the distance between a nozzle of the apparatus and a surface of the workpiece.

10. The method of any of the preceding claims, further comprising:
monitoring (140) the deposit parameter and/or the environmental parameter during the operation of the apparatus; and
dynamically updating the control instructions, based on the monitored deposit parameter and/or the environmental parameter, during the operation of the apparatus.

11. The method of any of claims 1 to 9, wherein said method is performed in a calibration process, and wherein the control instructions are stored in a database for subsequent use during production.

12. The method of any of the preceding claims, wherein the control instructions are stored in a database associating the control instructions with information relating to the type of viscous medium.

13. A method for generating a trained neural network model for generating control instructions for operating an apparatus forming a deposit of viscous medium on a workpiece, the method comprising:
a) operating (210) the apparatus to form a deposit;
b) measuring (220) a physical characteristic of the deposit;
c) recording (230) control instructions used when operating the apparatus to form the deposit, an environmental parameter affecting the forming of the deposit, and a deposit parameter indicating a physical characteristic of the deposit to be formed by the viscous medium, as input to the model; and
d) using the measured physical characteristic and recorded input to update 240 the neural network model.

14. The method of claim 13, comprising repeating steps a) to d) until the difference between the deposit parameter and the measured physical characteristic is within a predetermined interval.

15. A system comprising:
an apparatus (1) for forming a deposit of viscous medium (229 on a workpiece (23); and
a processing circuitry (32) for generating control instructions for operating the apparatus;
wherein the processing circuitry is configured to:
receive (110) an environmental parameter affecting the forming of the deposit;
receive (120) a deposit parameter indicating a physical characteristic of the deposit to be formed by the viscous medium; and to
process the environmental parameter and the deposit parameter through a neural network to generate (130) the control instructions for operating the apparatus.

16. The system of claim 15, further comprising an inspection tool configured to measure the physical characteristic of the deposit.

17. The system of claim 16, wherein the inspection tool is arranged downstream of the apparatus.

18. The system of any of claims 15-17, configured to perform the method of claims 1-14.
